(19) Europäisches Patentamt
European Patent Office
Office européen des brevets

(11) **EP 2 406 619 B1**

(12) **FASCICULE DE BREVET EUROPEEN**

(45) Date de publication et mention
de la délivrance du brevet:
**10.10.2018 Bulletin 2018/41**

(21) Numéro de dépôt: **10708172.1**

(22) Date de dépôt: **02.03.2010**

(51) Int Cl.:
**G01N 22/00** *(2006.01)*   **G01R 27/26** *(2006.01)*

(86) Numéro de dépôt international:
**PCT/EP2010/052605**

(87) Numéro de publication internationale:
**WO 2010/102925 (16.09.2010 Gazette 2010/37)**

(54) **PROCEDE ET DISPOSITIF DE MESURE DE LA PERMITTIVITE ET/OU PERMEABILITE**

VERFAHREN UND VORRICHTUNG ZUM MESSEN VON PERMITTIVITÄT UND/ODER PERMEABILITÄT

METHOD AND DEVICE FOR MEASURING PERMITTIVITY AND/OR PERMEABILITY

(84) Etats contractants désignés:
AT BE BG CH CY CZ DE DK EE ES FI FR GB GR HR HU IE IS IT LI LT LU LV MC MK MT NL NO PL PT RO SE SI SK SM TR

(30) Priorité: **13.03.2009 FR 0951598**

(43) Date de publication de la demande:
**18.01.2012 Bulletin 2012/03**

(73) Titulaire: **Commissariat à l'Energie Atomique
75015 Paris (FR)**

(72) Inventeurs:
• **FOURNEAUD, Ludovic**
  **F-38000 Grenoble (FR)**
• **DUSSOPT, Laurent**
  **F-38100 Grenoble (FR)**

(74) Mandataire: **Colombo, Michel et al
Brevinnov
310 avenue Berthelot
69008 Lyon (FR)**

(56) Documents cités:
**FR-A1- 2 905 761       JP-A- 2002 214 161
US-A1- 2008 191 711**

• **MOUKANDA F M ET AL: "A Cavity in Transmission for Extracting Electric Parameters of Thin Layers" SIGNALS, SYSTEMS AND ELECTRONICS, 2007. ISSSE '07. INTERNATIONAL SYMPOSIUM ON, IEEE, PI, 1 juillet 2007 (2007-07-01), pages 431-434, XP031129306 ISBN: 978-1-4244-1448-2**
• **ISABELLE HUYNEN ET AL: "A Wideband Line-Line Dielectrometric Method for Liquids, Soils, and Planar Substrates" IEEE TRANSACTIONS ON INSTRUMENTATION AND MEASUREMENT, IEEE SERVICE CENTER, PISCATAWAY, NJ, US, vol. 50, no. 5, 1 octobre 2001 (2001-10-01), XP011025366 ISSN: 0018-9456**
• **NG S K ET AL: "An Automated Microwave Waveguide Measurement Technique" MICROWAVE CONFERENCE, 2008. EUMC 2008. 38TH EUROPEAN, IEEE, PISCATAWAY, NJ, USA, 27 octobre 2008 (2008-10-27), pages 1322-1325, XP031407414 ISBN: 978-2-87487-006-4**

**Description**

L'invention concerne un procédé et un dispositif de mesure de la permittivité et/ou perméabilité d'un échantillon de matériau non conducteur.

Ici, a défaut d'indication contraire, par permittivité on désigne la permittivité diélectrique relative et par perméabilité on désigne la perméabilité magnétique relative.

Il existe des procédés de mesure de la permittivité d'un échantillon de matériau non conducteur comprenant :

a) la mesure d'une grandeur représentative d'une admittance $Y_{testco}$ uniquement à partir de l'amplitude et de la phase d'ondes électromagnétiques réfléchies sur une interface entre l'échantillon et une extrémité d'un premier guide d'onde, cette extrémité présentant au moins une âme séparée d'une gaine conductrice par une couche en matériau diélectrique dans laquelle se propagent les ondes électromagnétiques.

Par exemple, un tel procédé est divulgué dans la demande de brevet FR 2 651 580.

Ici, on considère qu'un échantillon de matériau est non conducteur si sa conductivité est inférieure à $10^{-2}$ S.m$^{-1}$ et, de préférence, à $10^{-3}$ S.m$^{-1}$.

Ces procédés connus sont également qualifiés de procédés « de caractérisation électromagnétique en réflexion » car ils n'utilisent que la réflexion des ondes électromagnétiques sur l'échantillon pour mesurer la permittivité.

Ces procédés de mesure par réflexion présentent de nombreux avantages. Par exemple, ils permettent :

- de réaliser des mesures sur des matériaux liquides, solides ou mous (poudres, matériaux élastiques,...),
- de faire des mesures non destructives car il n'est pas nécessaire d'usiner l'échantillon solide pour lui donner une forme spécifique autre qu'une surface plane, et
- de caractériser le matériau sur une large bande de fréquences (par exemple de 0 MHz à 20 GHz).

Toutefois, les procédés connus présentent l'inconvénient qu'ils ne peuvent pas être mis en oeuvre sur des échantillons présentant une perméabilité différente de 1. Ainsi avec ces procédés connus, la mesure de la permittivité d'une ferrite n'est pas possible par exemple.

De plus, seule la permittivité est mesurable à l'aide de ces procédés connus et non pas la perméabilité magnétique.

Pour remédier à ces inconvénients, des procédés de mesure de la permittivité et de la perméabilité ont été développés. Ces procédés utilisent, en plus de la réflexion, la transmission des ondes électromagnétiques au travers de l'échantillon. Un tel procédé de mesure par réflexion et transmission est décrit dans les demandes de brevet US2007/0090846 A1 et JP 2002 214161 A.

Ces procédés de mesure par réflexion et transmission nécessitent l'usinage ou la conformation de l'échantillon pour pouvoir le loger à l'intérieur d'un guide d'onde électromagnétique. Ceci est un inconvénient.

Pour remédier à cet inconvénient, la demande de brevet US2008/191711 propose d'utiliser deux guides d'onde placés l'un à côté de l'autre du même côté de l'échantillon. Des ondes électromagnétiques sont émises dans le premier guide d'onde. Une partie de ces ondes est réfléchie sur l'échantillon à l'interface avec l'échantillon et une autre partie se propage à travers l'échantillon jusqu'au second guide d'onde. Ensuite, la permittivité ou la perméabilité est mesurée à partir des ondes électromagnétiques réfléchies et transmises. Toutefois, le fait qu'une partie des mesures soit faite en transmission impose des contraintes importantes. Par exemple, la distance qui sépare les deux guides d'ondes doit être précisément connue. De plus, cela impose toujours l'utilisation simultanée de deux guides d'onde. La demande de brevet FR 2 905 761 propose d'utiliser deux guides d'onde différents afin de mesurer des admittances uniquement à partir des amplitudes et des phases d'ondes électromagnétiques réfléchies.

L'invention vise à remédier à au moins l'un de ces inconvénients.

Elle a donc pour objet un procédé de mesure de la permittivité et/ou perméabilité d'un échantillon de matériau non conducteur comportant :

b) la mesure d'une grandeur représentative d'une admittance $Y_{testcc}$ uniquement à partir de l'amplitude et de la phase des ondes électromagnétiques réfléchies sur une interface entre l'échantillon et l'extrémité d'un second guide d'onde présentant au moins une âme conductrice séparée d'une gaine conductrice par une couche en matériau diélectrique dans laquelle se propagent les ondes électromagnétiques, ce second guide d'onde comprenant aussi un court-circuit entre l'âme centrale et la gaine réalisé au niveau de l'interface avec l'échantillon de manière à ce que la phase et/ou l'amplitude des ondes électromagnétiques réfléchies sur l'échantillon soit(ent) différente(s) de celles obtenues en absence du court-circuit, et

c) le calcul de la permittivité de l'échantillon à partir des grandeurs représentatives des admittances $Y_{testco}$ et $Y_{testcc}$ et/ou le calcul de la perméabilité de l'échantillon à partir des grandeurs représentatives des admittances $Y_{testco}$ et

$Y_{testcc}$.

Le procédé ci-dessus permet de mesurer la permittivité d'échantillons ayant une perméabilité égale à 1 aussi bien que d'échantillons ayant une perméabilité différente de 1. Par exemple, la permittivité de ferrite peut être mesurée à l'aide du procédé ci-dessus.

Le procédé ci-dessus permet également de mesurer uniquement par réflexion d'ondes électromagnétiques sur l'échantillon à la fois la perméabilité et la permittivité de cet échantillon.

Ces résultats sont atteints sans utiliser de mesure en transmission. Plus précisément, l'utilisation d'un court-circuit, appelé par la suite « partiel », pour modifier la phase et/ou l'amplitude des ondes réfléchies par l'échantillon remplace avantageusement la mesure en transmission habituellement utilisée. Les problèmes liés à la mise en oeuvre d'une mesure par transmission sont donc évités. Un tel court-circuit partiel se distingue des court-circuits connus utilisés lors de phase de calibration. Les court-circuits connus sont utilisés pour mesurer les caractéristiques des guides d'ondes. Ces court-circuits connus ne sont pas mis en oeuvre pour mesurer des caractéristiques de l'échantillon. Au contraire, ces court-circuits connus sont employés pour isoler le guide d'onde de l'échantillon afin d'être uniquement sensible aux caractéristiques du guide d'onde. Ils ne contiennent donc aucune information sur l'échantillon à caractériser.

Enfin, le procédé ci-dessus conserve également tous les avantages liés à une mesure uniquement par réflexion par rapport aux procédés de mesure par réflexion et transmission.

Les modes de réalisation de ce procédé peuvent comporter une ou plusieurs des caractéristiques suivantes :

- ■ entre les étapes a) et b), le procédé comprend la commutation d'un interrupteur raccordé électriquement entre l'âme et la gaine pour passer du premier guide d'onde où l'âme et la gaine sont électriquement isolées l'une de l'autre, au second guide d'onde où l'âme et la gaine sont électriquement court-circuitées ;
- ■ les mesures des grandeurs représentatives des admittances $Y_{testco}$ et $Y_{testcc}$ sont réalisées avec des ondes électromagnétiques de même fréquence.

Ces modes de réalisation du procédé présentent en outre l'avantage suivant :

- la commutation d'un interrupteur pour passer du premier guide d'onde au second guide d'onde permet de passer rapidement de la mesure de l'admittance $Y_{testco}$ à la mesure de l'admittance $Y_{testcc}$ et vice-versa.

L'invention a également pour objet un support d'enregistrement d'informations comportant des instructions pour la mise en oeuvre du procédé ci-dessus, lorsque ces instructions sont exécutées par un calculateur électronique.

L'invention a également pour objet un dispositif de mesure de la permittivité et/ou perméabilité d'un échantillon de matériau non conducteur, ce dispositif comportant :

- un appareil de mesure de grandeurs représentatives d'admittances uniquement à partir de l'amplitude et de la phase d'ondes électromagnétiques réfléchies sur une interface entre l'échantillon et une extrémité d'un guide de ces ondes électromagnétiques,
- un premier guide d'onde présentant une première extrémité apte à être appliquée sur l'échantillon et une seconde extrémité opposée raccordable à l'appareil de mesure pour mesurer une grandeur représentative d'une admittance $Y_{testco}$, ce premier guide d'onde étant équipé d'au moins une âme conductrice séparée d'une gaine conductrice par une couche en matériau diélectrique dans laquelle se propagent les ondes électromagnétiques,
- un second guide d'onde présentant une première extrémité apte à être appliquée sur l'échantillon et une seconde extrémité opposée raccordable à l'appareil de mesure pour mesurer une grandeur représentative d'une admittance $Y_{testcc}$, ce second guide d'onde étant équipé d'au moins une âme conductrice séparée d'une gaine conductrice par une couche en matériau diélectrique dans laquelle se propagent les ondes électromagnétiques, ce second guide d'onde comprenant aussi un court-circuit entre l'âme et la gaine réalisé au niveau de l'interface avec l'échantillon de manière à ce que la phase et/ou l'amplitude des ondes électromagnétiques réfléchies sur l'échantillon soit(ent) différente(s) de celles obtenues en absence du court-circuit, et
- un calculateur apte à calculer la permittivité de l'échantillon à partir des grandeurs représentatives des admittances $Y_{testco}$ et $Y_{testcc}$ et/ou à calculer la perméabilité de l'échantillon à partir des grandeurs représentatives des admittances $Y_{testco}$ et $Y_{testcc}$.

Les modes de réalisation de ce dispositif peuvent comporter une ou plusieurs des caractéristiques suivantes :

- ■ l'âme, la gaine et le matériau diélectrique des premier et second guides d'onde sont communs, et le dispositif comprend un interrupteur raccordé électriquement entre l'âme et la gaine pour passer du premier guide d'onde où l'âme et la gaine sont électriquement isolées l'une de l'autre au second guide d'onde où l'âme et la gaine sont court-circuitées ;

▪ la première extrémité du second guide d'onde comporte une plaque métallique s'étendant de l'âme centrale jusqu'à la gaine pour court-circuiter l'âme et la gaine et obstruer une partie seulement de la section du matériau diélectrique dans lequel se propage les ondes électromagnétiques réfléchies sur l'échantillon ;

▪ le second guide d'onde est identique au premier guide d'onde à l'exception du fait qu'il comporte ladite plaque métallique ;

▪ la gaine entoure l'âme.

Ces modes de réalisation du dispositif présentent en outre l'avantage suivant :

- avoir des premier et second guides d'onde qui sont quasiment identiques permet d'avoir des plages de fréquences de travail pour ces guides d'onde quasiment identiques également.

L'invention sera mieux comprise à la lecture de la description qui va suivre, donnée uniquement à titre d'exemple non limitatif et faite en se référant aux dessins sur lesquels :

• La figure 1 est une illustration schématique d'un dispositif de mesure de la permittivité et de la perméabilité d'un échantillon de matériau non conducteur,
• La figure 2 est une illustration schématique et en perspective de l'extrémité d'un guide d'onde du dispositif de la figure 1,
• Les figures 3 et 4 sont des illustrations schématiques de l'extrémité de la figure 2 dans une configuration en circuit ouvert et dans une configuration en court-circuit partiel ainsi qu'une illustration des modèles électriques correspondants,
• La figure 5 est un organigramme d'un procédé de mesure de la permittivité et de la perméabilité d'un échantillon à l'aide du dispositif de la figure 1,
• La figure 6 est une illustration schématique d'un autre mode de réalisation d'un dispositif de mesure de la permittivité et de la perméabilité d'un échantillon, et
• La figure 7 est une illustration schématique et en perspective d'une extrémité d'un guide d'onde du dispositif de mesure de la figure 6.

Dans ces figures, les mêmes références sont utilisées pour désigner les mêmes éléments.

Dans la suite de cette description, les caractéristiques et fonctions bien connues de l'homme du métier ne sont pas décrites en détails.

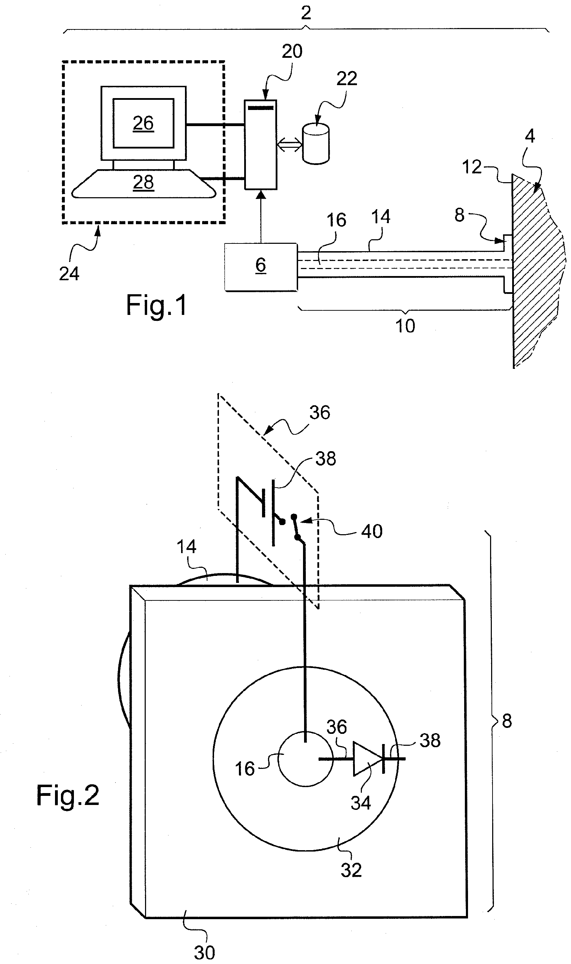

La figure 1 représente un dispositif 2 de mesure de la permittivité et de la perméabilité d'un échantillon 4 en matériau non conducteur. A titre d'illustration, l'échantillon 4 est un échantillon réalisé dans une matière dont la perméabilité est différente de 1. Par exemple l'échantillon 4 est une ferrite. L'échantillon 4 peut être une partie d'un objet ou la totalité de cette l'objet.

Le dispositif 2 comprend un appareil 6 de mesure de l'admittance au niveau de l'interface entre l'échantillon 4 et une sonde 8 formant l'extrémité d'un guide d'onde électromagnétique 10. L'admittance, notée Y, est l'inverse de l'impédance.

Une autre extrémité du guide 10 est électriquement raccordée à l'appareil 6.

Ici, l'appareil 6 est apte à générer des ondes électromagnétiques qui sont dirigées par le guide d'onde 10 jusqu'à une face plane 12 de l'échantillon 4. A cet effet, la sonde 8 est directement appliquée sur la face 12. L'appareil 6 mesure l'amplitude et la phase des ondes réfléchies au niveau de l'interface avec l'échantillon 4.

Par exemple, l'appareil 6 est un analyseur de réseau vectoriel également connu sous l'abréviation anglaise de VNA (Vectorial Network Analyser). Ces analyseurs sont connus et ne seront pas décrits ici plus en détail.

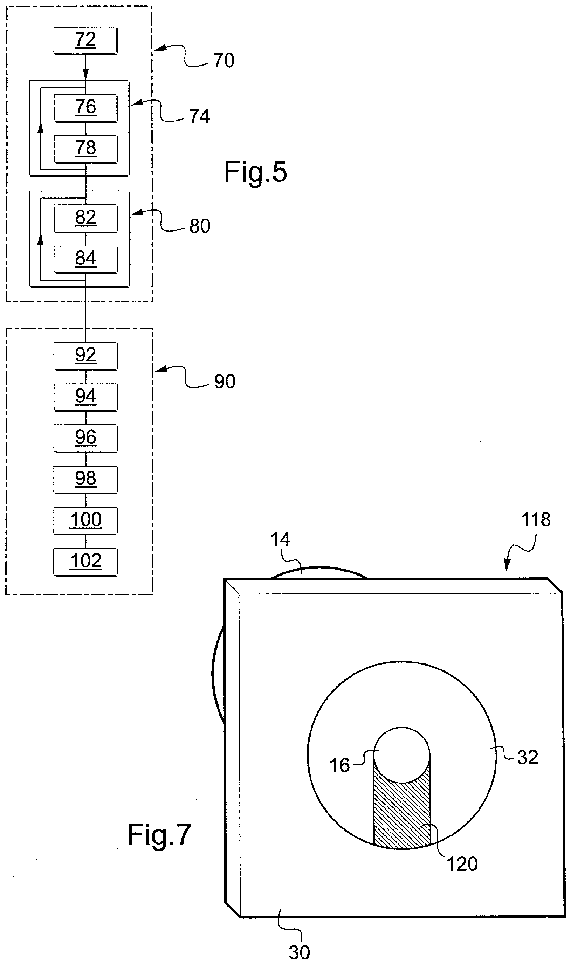

A titre d'illustration, l'appareil 6 est raccordé à un calculateur électronique 20 apte à calculer la permittivité et la perméabilité de l'échantillon 4 à partir des admittances mesurées par l'appareil 6. Par exemple, le calculateur 20 est un calculateur électronique programmable apte à exécuter des instructions enregistrées sur un support d'enregistrement d'informations. A cet effet, le calculateur 20 est raccordé à une mémoire 22 comportant les instructions nécessaires pour l'exécution du procédé de la figure 5.

Le guide d'onde 10 est formé d'une gaine conductrice 14 qui s'étendant autour d'une âme centrale conductrice 16. La gaine 14 et l'âme 16 sont, par exemple, en métal. La gaine 14 et l'âme 16 sont séparées l'une de l'autre par un matériau diélectrique dans lequel se propage les ondes électromagnétiques guidées. Par exemple, le guide d'onde 10 est un câble coaxial.

Le calculateur 20 est également raccordé à une interface homme-machine 24 pour communiquer les permittivités et perméabilités mesurées à un utilisateur. Par exemple, l'interface 24 est ici formée d'un écran 26 et d'un clavier 28.

La figure 2 représente plus en détail la sonde 8.

La sonde 8 comprend une bride 30 destinée à venir directement en appui sur la face 12 de l'échantillon 4. Cette bride 30 entoure la gaine 14.

Entre la gaine 14 et l'âme 16 est logé le matériau diélectrique 32 qui isole électriquement l'âme 16 de la gaine 14. Ici, sensiblement dans le plan de la bride 30, l'âme 16 est électriquement raccordée à la gaine 14 par l'intermédiaire d'un interrupteur commandable 34. Dans sa position fermée, l'interrupteur 34 court-circuite l'âme 16 et la gaine 14. Dans sa position ouverte, au contraire, l'âme 16 et la gaine 14 sont électriquement isolées l'une de l'autre. Les dimensions de cet interrupteur 34 ainsi que des conducteurs électriques 36 et 38 qui le raccordent, respectivement, à l'âme 16 et à la gaine 14 sont choisies de manière à ce qu'en position fermée une partie des ondes électromagnétiques se réfléchissent quand même sur l'échantillon 4. A cet effet, lorsque l'interrupteur est fermé, le court-circuit obstrue seulement une partie de la section transversale du matériau diélectrique 32. Ce court-circuit modifie la phase des ondes électromagnétiques réfléchies sur la face 12 par rapport au cas où l'interrupteur 34 est dans sa position ouverte. En effet, la phase de ces ondes réfléchies contient non seulement des informations sur le guide d'onde dans lequel ces ondes se propagent, mais également des informations sur l'échantillon. Ainsi, en position fermée, ce court-circuit constitue un court-circuit partiel. Les dimensions de l'interrupteur 34 et des conducteurs 36 et 38 peuvent également être choisies de manière à ce que la fermeture de l'interrupteur 34 provoque également une modification de l'amplitude des ondes électromagnétiques réfléchies sur la face 12 par rapport au cas où l'interrupteur 34 est dans sa position ouverte. Par exemple, ces modifications de la phase et/ou de l'amplitude sont au moins supérieure à 1% ou 10% de la phase et/ou de l'amplitude obtenue(s) dans le cas où l'interrupteur 34 est dans sa position ouverte.

De préférence, dans sa position fermée, les dimensions de l'interrupteur 34 et des conducteurs 36 et 38 sont choisies de manière à ce que le court-circuit créé corresponde également à un court-circuit électromagnétique propre à introduire un déphasage de 180° par rapport à la situation où l'interrupteur 34 est dans sa position ouverte.

De nombreux modes de réalisation différents sont possibles pour l'interrupteur 34. Par exemple, l'interrupteur 34 peut être réalisé à l'aide :

- de composants semi-conducteurs tels que des diodes, transistors ou thyristors,
- de microsystèmes mécaniques (MEMS), ou encore :
- de composants optoélectroniques (phototransistors).

Par exemple, sur la figure 2, l'interrupteur 34 est réalisé à l'aide d'une diode.

Le dispositif 2 comporte également une unité 36 de commande de l'interrupteur 34. Cette unité 36 est apte à commander la commutation de l'interrupteur 34 entre ses positions ouverte et fermée. Par exemple, la commutation entre les positions ouverte et fermée est déclenchée manuellement par un utilisateur.

Dans le cas d'une diode, l'unité 36 comporte, par exemple, une source 38 de tension continue raccordée entre la gaine 14 et l'âme 16. Cette source 38 est raccordée en série avec un commutateur 40. Lorsque le commutateur 40 est dans une position fermée, une tension continue est appliquée entre l'âme 16 et 14. Cette tension continue est choisie de manière à rendre passante la diode 34. Lorsque le commutateur 40 est dans sa position ouverte, aucune tension continue n'est appliquée entre la gaine 14 et l'âme 16 de sorte que la diode 34 est dans sa position ouverte et ne laisse donc pas passer le courant.

Lorsque l'interrupteur 34 est dans sa position fermée, il permet au courant alternatif à la fréquence de travail de se propager de l'âme 16 jusqu'à la gaine 14 par conductivité. A l'inverse, lorsque l'interrupteur 34 est dans sa position ouverte, ce courant alternatif à la fréquence de travail ne peut pas se propager par conductivité de l'âme 16 jusqu'à la gaine 14.

Le commutateur 40 est basculé entre ses positions ouverte et fermée manuellement par un opérateur. Par exemple, le commutateur 40 est un bouton-poussoir.

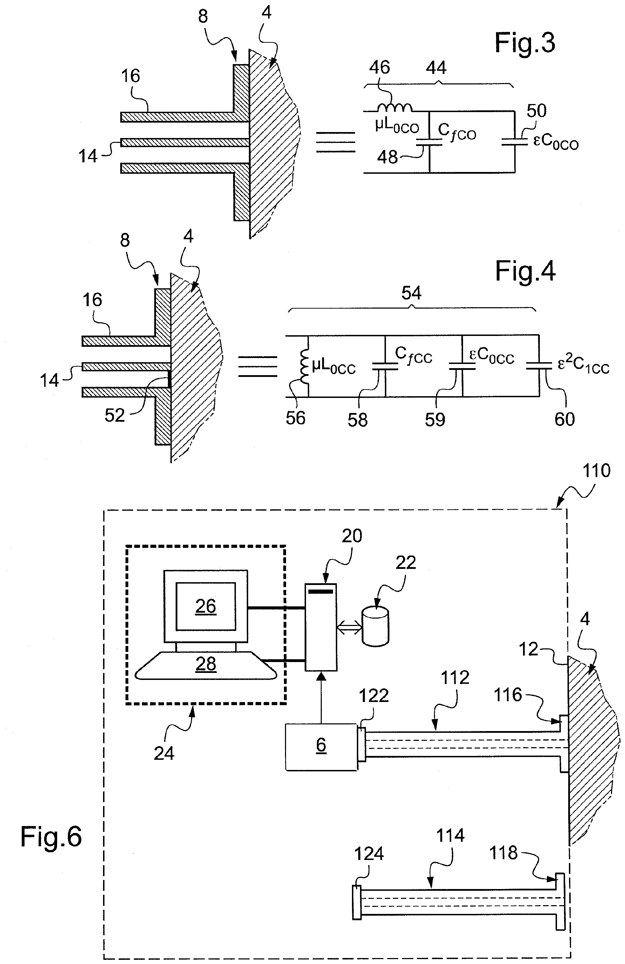

La figure 3 représente schématiquement et en coupe transversale la sonde 8 lorsque l'interrupteur 34 est dans sa position ouverte. On dit alors que cette sonde est en circuit ouvert. Dans cet état, l'interface entre l'extrémité 8 et l'échantillon 4 peut être modélisée à l'aide d'un modèle électrique 44. Ici, ce modèle électrique 44 comporte une inductance 46 raccordée en série avec un condensateur 48. Un condensateur 50 est également raccordé en parallèle aux bornes du condensateur 48. La valeur $\mu L_{0co}$ de l'inductance 46 est proportionnelle à la perméabilité $\mu$ de l'échantillon 4. La capacité $C_{fco}$ du condensateur 48 est indépendante de la permittivité et de la perméabilité. La capacité $\varepsilon C_{0co}$ du condensateur 50 est proportionnelle à la permittivité $\varepsilon$ de l'échantillon 4.

La figure 4 représente schématiquement et en coupe transversale la sonde 8 dans le cas où l'interrupteur 34 est dans sa position fermée. On dit alors que la sonde 8 est en court-circuit. Sur cette figure, le court-circuit entre l'âme 14 et la gaine 16 est représenté par un trait gras 52.

La sonde en court-circuit est modélisée à l'aide d'un modèle 54. Par exemple, le modèle 54 comporte, successivement raccordés en parallèle, une inductance 56 et trois condensateurs 58 à 60. La valeur $\mu L_{0cc}$ de l'inductance 56 est proportionnelle à la perméabilité $\mu$ de l'échantillon 4. La capacité $C_{fcc}$ du condensateur 58 est indépendante de la permittivité et de la perméabilité. Les capacités $\varepsilon C_{0cc}$, et $\varepsilon^2 C_{1cc}$, respectivement, des condensateurs 59 et 60 sont fonctions de la permittivité ε de l'échantillon 4.

A partir du modèle 44, il est possible d'estimer l'admittance $Y_{CO}$ mesurée par l'appareil 6 en circuit ouvert. Cette estimation est donnée par la relation suivante :

$$Y_{CO} = \frac{j\omega(C_{fco} + \varepsilon C_{0co})}{1 - \omega^2(C_{fco} + \varepsilon C_{0co})\mu L_{0co}} \qquad (1)$$

où :

- $\omega$ est la pulsation ($\omega = 2\pi f$, où f est la fréquence de travail en Hertz),
- j est le nombre complexe tel que $j^2 = -1$, et
- $L_{0co}$, $C_{fco}$, et $C_{0co}$ sont des paramètres du modèle 44 dont les valeurs sont indépendantes de la permittivité ε et de la perméabilité μ.

De façon similaire, à partir du modèle 54 il est possible d'estimer l'admittance $Y_{CC}$ mesurée par l'appareil 6 en court-circuit. Cette estimation est donnée par la relation suivante :

$$Y_{CC} = j\omega(C_{fcc} + \varepsilon C_{0cc} + \varepsilon^2 C_{1cc}) + \frac{1}{j\omega\mu L_{0cc}} \qquad (2)$$

où :

- $L_{0cc}$, $C_{fcc}$, $C_{0cc}$, et $C_{1cc}$ sont des paramètres du modèle 54 dont les valeurs sont indépendantes de la permittivité ε et de la perméabilité μ.

Le fonctionnement du dispositif 2 va maintenant être décrit en regard du procédé de la figure 5.

Le procédé débute par une phase 70 de calibration du dispositif 2. Initialement, au début de cette phase 70, lors d'une étape 72, l'appareil 6 est calibré. Cette étape 72 est conventionnelle et ne sera pas décrite plus en détail.

Ensuite, on procède à une étape 74 de calibration de la sonde 8 en circuit ouvert. Cette étape 74 a pour but de déterminer la valeur des paramètres $C_{fco}$, $C_{0co}$ et $L_{0co}$. Pour cette étape 74, on utilise des échantillons étalons. La permittivité et la perméabilité de ces échantillons étalons sont connues à l'avance. Par exemple, lors de l'étape 74, on utilise trois échantillons étalons choisis dans le groupe composé de l'eau déionisée, le téflon, l'air et un matériau magnétique-diélectrique dont la permittivité et la perméabilité sont égales à 5.

Plus précisément, lors d'une opération 76, le premier échantillon étalon est placé à la place de l'échantillon 4. Autrement dit, la sonde 8 est appliquée sur une face plane de cet échantillon étalon. Puis, dans ces conditions, l'admittance $Y_{ref1co}$ est mesurée par l'appareil 6. Ensuite, on réitère l'opération 76 pour le deuxième et troisième échantillons étalons de manière à mesurer, respectivement, les admittances $Y_{ref2co}$ et $Y_{ref3co}$.

Ensuite, lors d'une opération 78, le calculateur 20 détermine à partir des mesures $Y_{ref1co}$, $Y_{ref2co}$ et $Y_{ref3co}$ ainsi qu'à partir des valeurs connues de permittivité $E_{ref1}$, $\varepsilon_{ref2}$ et $\varepsilon_{ref3}$ et de perméabilité $\mu_{ref1}$, $\mu_{ref2}$ et $\mu_{ref3}$, respectivement, des premier, deuxième et troisième échantillons étalons, la valeur des paramètres $C_{0co}$, $C_{fco}$ et $L_{0co}$. Par exemple, à cet effet, le système d'équations suivant est résolu :

$$\begin{cases} \dfrac{j\omega(\varepsilon_{ref1}C_{0co} + C_{fco})}{-\omega^2(C_{fco} + \varepsilon_{ref1}C_{0co})\mu_{ref1}L_{0co} + 1} = Y_{ref1co} \\[2em] \dfrac{j\omega(\varepsilon_{ref2}C_{0co} + C_{fco})}{-\omega^2(C_{fco} + \varepsilon_{ref2}C_{0co})\mu_{ref2}L_{0co} + 1} = Y_{ref2co} \\[2em] \dfrac{j\omega(\varepsilon_{ref3}C_{0co} + C_{fco})}{-\omega^2(C_{fco} + \varepsilon_{ref3}C_{0co})\mu_{ref3}L_{0co} + 1} = Y_{ref3co} \end{cases} \qquad (3)$$

La valeur des paramètres $C_{0co}$, $C_{fco}$ et $L_{0co}$ dépend de la fréquence de travail de l'onde électromagnétique et donc de la fréquence du courant d'excitation circulant dans l'âme 16 utilisée pour mesurer l'admittance. Par conséquent, les opérations 76 et 78 sont de préférence réitérées pour un grand nombre de fréquences différentes régulièrement réparties dans la plage des fréquences de travail possibles. Par exemple, cette plage des fréquences de travail possibles s'étend de 0 MHz jusqu'à 20 GHz. De préférence, la plage des fréquences de travail est comprise entre 100 MHz et 10 GHz.

Une fois l'étape 74 terminée, on procède à une étape 80 de calibration de la sonde 8 en court-circuit. Pour cela, l'interrupteur 34 est commuté dans sa position fermée et l'admittance de quatre échantillons étalons est mesurée à l'aide du dispositif 2 lors d'une opération 82. Comme précédemment, les permittivités et perméabilités connues de ces échantillons étalons sont notées, respectivement, $\varepsilon_{ref1}$, $\varepsilon_{ref2}$, $\varepsilon_{ref3}$ et $\varepsilon_{ref4}$ tandis que les perméabilités connues sont notées $\mu_{ref1}$, $\mu_{ref2}$, $\mu_{ref3}$ et $\mu_{ref4}$. Les échantillons étalons sont par exemple choisis dans le même groupe que celui décrit en regard de l'étape 74.

Lors d'une opération 82, les admittances respectives $Y_{ref1}$, $Y_{ref2}$, $Y_{ref3}$ et $Y_{ref4}$ de chacun de ces échantillons étalons sont mesurées à l'aide de l'appareil 6.

Ensuite, lors d'une opération 84, les valeurs des paramètres $C_{fcc}$, $C_{0co}$, $C_{1cc}$ et $L_{0cc}$ sont calculées à partir des admittances mesurées $Y_{ref1}$, $Y_{ref2}$, $Y_{ref3}$ et $Y_{ref4}$ ainsi qu'à partir des valeurs connues de perméabilité et de permittivité des échantillons étalons. Par exemple, lors de l'opération 84, le système d'équations suivant est résolu :

$$
\left\{
\begin{aligned}
Y_{ref\,1} &= j\omega\left(C_{fcc} + \varepsilon_{ref\,1} C_{0cc} + \varepsilon_{ref\,1}^2 C_{1cc}\right) + \frac{1}{j\omega\mu_{ref1} L_{0cc}} \\[2mm]
Y_{ref\,2} &= j\omega\left(C_{fcc} + \varepsilon_{ref\,2} C_{0cc} + \varepsilon_{ref\,2}^2 C_{1cc}\right) + \frac{1}{j\omega\mu_{ref2} L_{0cc}} \\[2mm]
Y_{ref\,3} &= j\omega\left(C_{fcc} + \varepsilon_{ref\,3} C_{0cc} + \varepsilon_{ref\,3}^2 C_{1cc}\right) + \frac{1}{j\omega\mu_{ref3} L_{0cc}} \\[2mm]
Y_{ref\,4} &= j\omega\left(C_{fcc} + \varepsilon_{ref\,4} C_{0cc} + \varepsilon_{ref\,4}^2 C_{1cc}\right) + \frac{1}{j\omega\mu_{ref4} L_{0cc}}
\end{aligned}
\right.
\tag{4}
$$

Les opérations 82 et 84 sont réitérées pour plusieurs fréquences de travail régulièrement réparties dans la plage des fréquences de travail. De préférence, les mêmes fréquences de travail que celles utilisées lors de l'étape 74 sont utilisées lors de l'étape 80.

Une fois le dispositif 2 calibré, la phase 70 se termine et une phase 90 de mesure de la permittivité et de la perméabilité de l'échantillon 4 peut être déclenchée.

Au début de la phase 90, lors d'une étape 92, la sonde 8 est mise en appui sur la face 12 de l'échantillon 4 pour lequel la permittivité $\varepsilon_{test}$ et la perméabilité $\mu_{test}$ doivent être mesurées.

Ensuite, lors d'une étape 94, l'interrupteur 30 est commuté dans sa position ouverte et l'admittance $Y_{testco}$ est mesurée à l'aide de l'appareil 6. De préférence, l'étape 94 est réitérée pour les mêmes fréquences de travail que celles utilisées lors de l'étape 74 de sorte que plusieurs mesures de l'admittance $Y_{testco}$ sont obtenues.

Ensuite, lors d'une étape 96, l'interrupteur est commuté dans sa position fermée.

Puis, lors d'une étape 98, l'admittance $Y_{testcc}$ est mesurée par l'appareil 6 pour les différentes fréquences de travail utilisées.

Lors d'une étape 100, le calculateur 20 calcule la permittivité $\varepsilon_{test}$ et la perméabilité $\mu_{test}$ pour chacune des fréquences de travail utilisées lors des étapes 94 et 98. La perméabilité $\varepsilon_{test}$ et la perméabilité $\mu_{test}$ sont obtenues, chacune, à partir des valeurs des admittances $Y_{testco}$ et $Y_{testcc}$ mesurées à la même fréquence. Par exemple, la permittivité $\varepsilon_{test}$ et la perméabilité $\mu_{test}$ sont calculées en résolvant le système d'équations suivant :

$$
\left\{
\begin{aligned}
& y_{testco} - \frac{j\omega\left(C_{fco} + \varepsilon_{test} C_{0co}\right)}{1 - \omega^2\left(C_{fco} + \varepsilon_{test} C_{0co}\right)\mu_{test} L_{0co}} = 0 \\[3mm]
& y_{testcc} - j\omega\left(C_{fcc} + \varepsilon_{test} C_{0cc} + \varepsilon_{test}^2 C_{1cc}\right) - \frac{1}{j\omega\mu_{test} L_{0cc}} = 0
\end{aligned}
\right.
\tag{5}
$$

où :

- $C_{fco}$, $C_{0co}$, $L_{0co}$, $L_{0cc}$, $C_{fcc}$, $C_{0cc}$ et $C_{1cc}$ sont les valeurs des paramètres mesurés ou interpolés à partir des mesures réalisées lors de la phase 70,

- $Y_{testco}$ et $Y_{testcc}$ sont les admittances mesurées en circuit ouvert et en circuit fermé pour cette fréquence de travail.

Le système d'équations ci-dessus peut être résolu analytiquement. Toutefois, il présente trois solutions. Pour choisir la bonne solution, on choisit la solution qui présente la permittivité la plus proche de 1. Par exemple, à cet effet, ce système d'équations est résolu à l'aide d'une résolution de type Newton initialisée en prenant la perméabilité $\mu_{test}$ égale à 1.

Une fois que la permittivité $\varepsilon_{test}$ et la perméabilité $\mu_{test}$ ont été calculées lors de l'étape 100, celles-ci sont présentées, lors d'une étape 102 à l'utilisateur via l'interface homme-machine 24 ou enregistrées dans un fichier.

La figure 6 présente un autre mode de réalisation d'un dispositif 110 de mesure de la permittivité et de la perméabilité de l'échantillon 4. Ce dispositif 110 est identique au dispositif 2 à l'exception que le guide d'onde 10 est remplacé par deux guides d'onde 112 et 114. Les guides d'onde 112 et 114 présentent, respectivement, des extrémités 116 et 118 destinées à venir en appui directement sur la face 12 lorsqu'une mesure d'admittance est réalisée. L'extrémité 116 forme une sonde en circuit ouvert. Par exemple, l'extrémité 116 est identique à la sonde 8 à l'exception du fait que l'interrupteur 34, les conducteurs 36 et 38 ainsi que l'unité de commande 36 ont été omis. Ainsi, la sonde 116 présente uniquement une configuration en circuit ouvert.

A l'inverse, l'extrémité 118 forme une sonde présentant uniquement une configuration en court-circuit partiel. Cette sonde 118 est représentée plus en détail sur la figure 7. Cette sonde 118 est par exemple identique à la sonde 8 à l'exception du fait que l'interrupteur 34, et les conducteurs 36 et 38 sont remplacés par une fine plaque métallique 120 qui s'étend de l'âme 16 jusqu'à la gaine 14. Les dimensions de cette plaque 120 sont suffisantes pour modifier la phase et/ou l'amplitude des ondes électromagnétiques réfléchies par la face 12 par rapport au cas où la plaque serait omise. Par exemple, cette modification de la phase et/ou de l'amplitude est au moins supérieure à 1% ou 10% de la phase et/ou de l'amplitude obtenue(s) dans le cas où la plaque 120 est omise Par exemple, la largeur de la plaque 120 est égale au diamètre de l'âme 16.

L'autre extrémité des guides d'onde 112 et 114 est équipée, respectivement, de connecteurs 122 et 124. Ces connecteurs 122 et 124 permettent de connecter et, en alternance, de déconnecter les guides d'onde 112 et 114 à l'appareil 6.

Le fonctionnement du dispositif 110 est identique à celui décrit en regard du procédé de la figure 5 à l'exception du fait que pour passer de la sonde en en circuit ouvert à la sonde en circuit fermé, il faut ici remplacer le guide d'onde 112 par le guide d'onde 114 et vice versa.

De nombreuses autres modes de réalisation sont possibles. Par exemple, la section des guides d'onde n'est pas nécessairement circulaire comme dans le cas de câbles coaxiaux. Par exemple, les sections de la gaine et/ou de l'âme peuvent être rectangulaires.

Les guides d'onde peuvent avoir plusieurs âmes.

Dans le dispositif 110, il n'est pas nécessaire que les premier et second guides d'onde soient structurellement identiques à la plaque métallique 120 près. Par exemple, les dimensions des guides d'onde 112 et 114 peuvent différer. Par exemple, les dimensions de la gaine et de l'âme (par exemple leur diamètre respectif), peuvent différer entre ces deux guides d'onde.

En variante, le calculateur calcule uniquement la permittivité à partir des admittances mesurées $Y_{testco}$ et $Y_{testcc}$ sans délivrer à l'utilisateur la valeur de la perméabilité $\mu_{test}$. Cela permet de mesurer la permittivité de matériau pour lesquelles la perméabilité est différente de 1 (par exemple la ferrite). Inversement, le calculateur peut également calculer uniquement la perméabilité $\mu_{test}$ à partir des admittances mesurées $Y_{testco}$ et $Y_{testcc}$ sans délivrer à l'utilisateur la permittivité $\varepsilon_{test}$.

D'autres modèles électriques que ceux représentés ici peuvent être utilisés à partir du moment où ils font apparaître la permittivité et la perméabilité de l'échantillon. Ces autres modèles peuvent être obtenus à partir d'équations du rayonnement des ondes électromagnétiques. En particulier, des modèles plus complexes peuvent être utilisés à la place de ceux représentés.

L'extrémité des guides d'ondes ne se présente pas nécessairement sous la forme d'une sonde. Par exemple, l'extrémité du guide d'onde peut directement être appliquée sur l'échantillon sans présenter de bride ou moyen similaire.

Ici, les dispositifs 2 et 110 ont été décrits dans le cas particulier où les mesures d'admittance sont directement transmises au calculateur par l'intermédiaire d'une liaison filaire. En variante, cette liaison filaire est omise et les mesures réalisées par l'appareil 6 sont saisies à l'aide du clavier 28 afin de les communiquer au calculateur 20 chargé de faire les calculs de permittivité et de perméabilité.

Enfin, les dispositifs 2 et 110 et les différents systèmes d'équations ont été décrits dans le particulier où les grandeurs mesurées sont des admittances. Toutefois, les dispositifs 2 et 110 peuvent être adaptés pour mesurer non pas directement les admittances mais une grandeur représentative de l'admittance. Par « grandeur représentative d'une admittance » on désigne une grandeur physique mesurable à l'aide d'un appareil et à partir de laquelle il est possible de déduire la valeur de l'admittance sans mesure complémentaire. Par exemple, l'impédance et le coefficient de réflexion des ondes électromagnétiques sur la face 12 sont des grandeurs représentatives de l'admittance. Dans le cas où une grandeur représentative de l'admittance, autre que l'admittance elle-même, est utilisée, alors les systèmes d'équations décrits précédemment sont adaptés pour tenir compte de cette différence.

**Revendications**

1. Procédé de mesure de la permittivité et/ou perméabilité d'un échantillon de matériau non conducteur, ce procédé comportant :

   a) la mesure (94) d'une grandeur représentative d'une admittance $Y_{testco}$ uniquement à partir de l'amplitude et de la phase d'ondes électromagnétiques réfléchies sur une interface entre l'échantillon et une extrémité d'un premier guide d'onde, cette extrémité présentant au moins une âme conductrice séparée d'une gaine conductrice par une couche en matériau diélectrique dans laquelle se propagent les ondes électromagnétiques,

   b) la mesure (98) d'une grandeur représentative d'une admittance $Y_{testcc}$ uniquement à partir de l'amplitude et de la phase des ondes électromagnétiques réfléchies sur une interface entre l'échantillon et l'extrémité d'un second guide d'onde présentant au moins une âme conductrice séparée d'une gaine conductrice par une couche en matériau diélectrique dans laquelle se propagent les ondes électromagnétiques, **caractérisé en ce que**:

   ce second guide d'onde comprend aussi un court-circuit entre l'âme centrale et la gaine réalisé au niveau de l'interface avec l'échantillon de manière à ce que la phase et/ou l'amplitude des ondes électromagnétiques réfléchies sur l'échantillon soit(ent) différente(s) de celles obtenues en absence du court-circuit, et **en ce que** le procédé comprend

   c) le calcul (100) de la permittivité de l'échantillon à partir des grandeurs représentatives des admittances $Y_{testco}$ et $Y_{testcc}$ et/ou le calcul (100) de la perméabilité de l'échantillon à partir des grandeurs représentatives des admittances $Y_{testco}$ et $Y_{testcc}$.

2. Procédé selon la revendication 1, dans lequel entre les étapes a) et b), le procédé comprend la commutation (94, 96) d'un interrupteur raccordé électriquement entre l'âme et la gaine pour passer du premier guide d'onde où l'âme et la gaine sont électriquement isolées l'une de l'autre, au second guide d'onde où l'âme et la gaine sont électriquement court-circuitées.

3. Procédé selon l'une quelconque des revendications précédentes, dans lequel les mesures (94, 98) des grandeurs représentatives des admittances $Y_{testco}$ et $Y_{testcc}$ sont réalisées avec des ondes électromagnétiques de même fréquence.

4. Support d'enregistrement d'informations, **caractérisé en ce qu'**il comporte des instructions pour la mise en oeuvre d'un procédé conforme à l'une quelconque des revendications précédentes, lorsque ces instructions sont exécutées par le calculateur (20) du dispositif selon l'une des revendications 5 à 9.

5. Dispositif de mesure de la permittivité et/ou perméabilité d'un échantillon de matériau non conducteur, ce dispositif comportant :

   - un appareil (6) de mesure de grandeurs représentatives d'admittances uniquement à partir de l'amplitude et de la phase d'ondes électromagnétiques réfléchies sur une interface entre l'échantillon et une extrémité d'un guide de ces ondes électromagnétiques,

   - un premier guide d'onde (10 ; 112) présentant une première extrémité (8 ; 116) apte à être appliquée sur l'échantillon et une seconde extrémité opposée raccordable à l'appareil de mesure pour mesurer grandeur représentative d'une admittance $Y_{testco}$, ce premier guide d'onde étant équipé d'au moins une âme conductrice (16) séparée d'une gaine conductrice (14) par une couche en matériau diélectrique (32) dans laquelle se propagent les ondes électromagnétiques,

   - un second guide d'onde (10 ; 114) présentant une première extrémité (8 ; 118) apte à être appliquée sur l'échantillon et une seconde extrémité opposée raccordable à l'appareil de mesure pour mesurer grandeur représentative d'une admittance $Y_{testcc}$, ce second guide d'onde étant équipé d'au moins une âme conductrice (16) séparée d'une gaine conductrice (14) par une couche en matériau diélectrique dans laquelle se propagent les ondes électromagnétiques, **caractérisé en ce que**:

   ce second guide d'onde comprend aussi un court-circuit (52; 120) entre l'âme et la gaine réalisé au niveau de l'interface avec l'échantillon de manière à ce que la phase et/ou l'amplitude des ondes électromagnétiques réfléchies sur l'échantillon soit(ent) différente(s) de celles obtenues en absence du court-circuit, et **en ce que** le dispositif comprend

- un calculateur (20) apte à calculer la permittivité de l'échantillon à partir des grandeurs représentatives des admittances $Y_{testco}$ et $Y_{testcc}$ et/ou à calculer la perméabilité de l'échantillon à partir des grandeurs représentatives des admittances $Y_{testco}$ et $Y_{testcc}$.

6. Dispositif selon la revendication 5, dans lequel :

- l'âme (16), la gaine (14) et le matériau diélectrique (32) des premier et second guides d'onde sont communs, et
- le dispositif comprend un interrupteur (34) raccordé électriquement entre l'âme et la gaine pour passer du premier guide d'onde où l'âme et la gaine sont électriquement isolées l'une de l'autre au second guide d'onde où l'âme et la gaine sont court-circuitées.

7. Dispositif selon la revendication 5, dans lequel la première extrémité (118) du second guide d'onde (114) comporte une plaque métallique (120) s'étendant de l'âme centrale jusqu'à la gaine pour court-circuiter l'âme et la gaine et obstruer une partie seulement de la section du matériau diélectrique dans lequel se propage les ondes électromagnétiques réfléchies sur l'échantillon.

8. Dispositif selon la revendication 7, dans lequel le second guide d'onde (114) est identique au premier guide d'onde (112) à l'exception du fait qu'il comporte ladite plaque métallique (120).

9. Dispositif selon l'une quelconque des revendications 5 à 8, dans lequel la gaine (14) entoure complètement l'âme (16).

**Patentansprüche**

1. Verfahren zum Messen der Permittivität und/oder der Permeabilität einer Probe eines nicht leitenden Materials, wobei dieses Verfahren Folgendes umfasst:

a) Messen (94) einer Größe, die eine Admittanz $Y_{testco}$ repräsentiert, ausschließlich anhand der Amplitude und der Phase elektromagnetischer Wellen, die an einer Grenzfläche zwischen der Probe und einem Ende eines ersten Wellenleiters reflektiert werden, wobei dieses Ende wenigstens einen leitenden Kern aufweist, der von einer leitenden Hülle durch eine Schicht aus einem dielektrischen Material, in der sich die elektromagnetischen Wellen ausbreiten, getrennt ist,

b) Messen (98) einer Größe, die eine Admittanz $Y_{testcc}$ repräsentiert, ausschließlich anhand der Amplitude und der Phase elektromagnetischer Wellen, die an einer Grenzfläche zwischen der Probe und dem Ende eines zweiten Wellenleiters reflektiert werden, das wenigstens einen leitenden Kern aufweist, der von einer leitenden Hülle durch eine Schicht aus einem dielektrischen Material, in dem sich die elektromagnetischen Wellen ausbreiten, getrennt ist,

**dadurch gekennzeichnet, dass**:

dieser zweite Wellenleiter außerdem zwischen dem zentralen Kern und der Hülle einen Kurzschluss aufweist, der auf Höhe der Grenzfläche mit der Probe verwirklicht ist, derart, dass die Phase und/oder die Amplitude elektromagnetischer Wellen, die an der Probe reflektiert werden, von jenen, die bei Abwesenheit des Kurzschlusses erhalten werden, verschieden sind, und

dass das Verfahren Folgendes umfasst:

c) Berechnen (100) der Permittivität der Probe anhand von Größen, die die Admittanzen $Y_{testco}$ und $Y_{testcc}$ repräsentieren, und/oder Berechnen (100) der Permeabilität der Probe anhand von Größen, die die Admittanzen $Y_{testco}$ und $Y_{testcc}$ repräsentieren.

2. Verfahren nach Anspruch 1, wobei das Verfahren zwischen den Schritten a) und b) das Umschalten (94, 96) eines Ein/Aus-Schalters, der zwischen dem Kern und der Hülle elektrisch angeschlossen ist, umfasst, um von dem ersten Wellenleiter, bei dem der Kern und die Hülle elektrisch voneinander isoliert sind, zu dem zweiten Wellenleiter, bei dem der Kern und die Hülle elektrisch kurzgeschlossen sind, überzugehen.

3. Verfahren nach einem der vorhergehenden Ansprüche, wobei die Messungen (94, 98) der Größen, die Admittanzen

$Y_{testco}$ und $Y_{testcc}$ repräsentieren, mit elektromagnetischen Wellen derselben Frequenz ausgeführt werden können.

4.  Datenaufzeichnungsträger, **dadurch gekennzeichnet, dass** er Befehle umfasst, um ein Verfahren nach einem der vorhergehenden Ansprüche auszuführen, wenn diese Befehle von dem Computer (20) der Vorrichtung nach einem der Ansprüche 5 bis 9 abgearbeitet werden.

5.  Vorrichtung zum Messen der Permittivität und/oder der Permeabilität einer Probe eines nicht leitenden Materials, wobei diese Vorrichtung Folgendes umfasst:

    - eine Einrichtung (6) zum Messen von Größen, die Admittanzen repräsentieren, ausschließlich anhand der Amplitude und der Phase elektromagnetischer Wellen, die an einer Grenzfläche zwischen der Probe und einem Ende eines Leiters dieser elektromagnetischen Wellen reflektiert werden,
    - einen ersten Wellenleiter (10; 112), der ein erstes Ende (8; 116), das an der Probe angebracht werden kann, und ein gegenüberliegendes zweites Ende, das mit der Messeinrichtung verbunden werden kann, um eine Größe zu messen, die eine Admittanz $Y_{testco}$ repräsentiert, aufweist, wobei dieser erste Wellenleiter mit wenigstens einem leitenden Kern (16) versehen ist, der von einer leitenden Hülle (14) durch eine Schicht (32) aus einem dielektrischen Material, in der sich die elektromagnetischen Wellen ausbreiten, getrennt ist,
    - einen zweiten Wellenleiter (10; 114), der ein erstes Ende (8; 118), das an der Probe angebracht werden kann, und ein gegenüberliegendes zweites Ende, das mit der Messvorrichtung verbunden werden kann, um eine Größe zu messen, die eine Admittanz $Y_{testcc}$ repräsentiert, aufweist, wobei dieser zweite Wellenleiter mit wenigstens einem leitenden Kern (16) ausgestattet ist, der von einer leitenden Hülle (14) durch eine Schicht aus einem dielektrischen Material, in dem sich die elektromagnetischen Wellen ausbreiten, getrennt ist,

    **dadurch gekennzeichnet, dass**:

    dieser zweite Wellenleiter außerdem zwischen dem Kern und der Hülle einen Kurzschluss (52; 120) aufweist, der auf Höhe der Grenzfläche mit der Probe verwirklicht ist, derart, dass die Phase und/oder die Amplitude elektromagnetischer Wellen, die an der Probe reflektiert werden, von jenen, die bei Abwesenheit des Kurzschlusses erhalten werden, verschieden sind, und dass die Vorrichtung Folgendes umfasst:

    - einen Computer (20), der die Permittivität der Probe anhand von Größen berechnen kann, die die Admittanzen $Y_{testco}$ und $Y_{testcc}$ repräsentieren, und/oder die Permeabilität der Probe anhand von Größen, die die Admittanzen $Y_{testco}$ und $Y_{testcc}$ repräsentieren, berechnen kann.

6.  Vorrichtung nach Anspruch 5, wobei:

    - der Kern (16), die Hülle (14) und das dielektrische Material (32) dem ersten und dem zweiten Wellenleiter gemeinsam sind, und
    - die Vorrichtung einen Ein/Aus-Schalter (34) umfasst, der zwischen dem Kern und der Hülle elektrisch angeschlossen ist, um von dem ersten Wellenleiter, bei dem der Kern und die Hülle voneinander elektrisch isoliert sind, zu dem zweiten Wellenleiter, bei dem der Kern und die Hülle kurzgeschlossen sind, überzugehen.

7.  Vorrichtung nach Anspruch 5, wobei das erste Ende (118) des zweiten Wellenleiters (114) eine Metallplatte (120) aufweist, die sich von dem zentralen Kern bis zu der Hülle erstreckt, um den Kern und die Hülle kurzzuschließen und um lediglich einen Teil des Querschnitts des dielektrischen Materials, in dem sich die an der Probe reflektierten elektromagnetischen Wellen ausbreiten, zu blockieren.

8.  Vorrichtung nach Anspruch 7, wobei der zweite Wellenleiter (114) abgesehen von der Tatsache, dass er die Metallplatte (120) enthält, dem ersten Wellenleiter (112) gleicht.

9.  Vorrichtung nach einem der Ansprüche 5 bis 8, wobei die Hülle (14) den Kern (16) vollständig umgibt.

**Claims**

1.  Method for measuring the permittivity and/or permeability of a sample of nonconductive material, this method including:

a) measuring (94) a quantity representative of an admittance $Y_{testco}$ solely on the basis of the amplitude and of the phase of electromagnetic waves reflected from an interface between the sample and an end of a first waveguide, this end having at least one conductive core that is separated from a conductive cladding by a layer made of dielectric material through which the electromagnetic waves propagate;

b) measuring (98) a quantity representative of an admittance $Y_{testcc}$ solely on the basis of the amplitude and of the phase of electromagnetic waves reflected from an interface between the sample and the end of a second waveguide having at least one conductive core that is separated from a conductive cladding by a layer made of dielectric material through which the electromagnetic waves propagate, **characterized in that**:

the second waveguide also comprises a short-circuit between the central core and the cladding, said short-circuit being formed at the interface with the sample so that the phase and/or amplitude of the electromagnetic waves reflected from the sample are/is different from the phase and/or amplitude obtained in the absence of the short-circuit; and in the that the method comprises

c) computing (100) the permittivity of the sample on the basis of the quantities representative of the admittances $Y_{testco}$ and $Y_{testcc}$ and/or computing (100) the permeability of the sample on the basis of the quantities representative of the admittances $Y_{testco}$ and $Y_{testcc}$.

2. Method according to Claim 1, wherein, between steps a) and b), the method comprises switching (94, 96) a switch that is electrically connected between the core and the cladding in order to pass from the first waveguide in which the core and cladding are electrically insulated from each other, to the second waveguide in which the core and cladding are electrically short-circuited.

3. Method according to either one of the preceding claims, wherein the measurements (94, 98) of the quantities representative of the admittances $Y_{testco}$ and $Y_{testcc}$ are carried out with electromagnetic waves of the same frequency.

4. Data storage medium, **characterized in that** it includes instructions for implementing a method according to any one of the preceding claims, when these instructions are executed by the computer (20) of the device according to one of Claims 5 to 9.

5. Device for measuring the permittivity and/or permeability of a sample of nonconductive material, this device including:

- an apparatus (6) for measuring quantities representative of admittances solely on the basis of the amplitude and of the phase of electromagnetic waves reflected from an interface between the sample and an end of a guide of these electromagnetic waves;
- a first waveguide (10; 112) having a first end (8; 116) that is able to be applied to the sample and an opposite second end that is connectable to the measuring apparatus in order to measure a quantity representative of an admittance $Y_{testco}$, this first waveguide being equipped with at least one conductive core (16) that is separated from a conductive cladding (14) by a layer made of dielectric material (32) through which the electromagnetic waves propagate;
- a second waveguide (10; 114) having a first end (8; 118) that is able to be applied to the sample and an opposite second end that is connectable to the measuring apparatus in order to measure a quantity representative of an admittance $Y_{testcc}$, the second waveguide being equipped with at least one conductive core (16) that is separated from a conductive cladding (14) by a layer made of dielectric material through which the electromagnetic waves propagate,

**characterized in that**:

the second waveguide also comprises a short-circuit (52; 120) between the core and the cladding, said short-circuit being produced at the interface with the sample so that the phase and/or amplitude of the electromagnetic waves reflected from the sample are/is different from the phase and/or amplitude obtained in the absence of the short-circuit;

and **in that** the device comprises

- a computer (20) that is able to compute the permittivity of the sample on the basis of the quantities representative of the admittances $Y_{testco}$ and $Y_{testcc}$ and/or to compute the permeability of the sample on the basis of the quantities representative of the admittances $Y_{testco}$ and $Y_{testcc}$.

6. Device according to Claim 5, wherein:

- the core (16), the cladding (14) and the dielectric material (32) of the first and second waveguides are common; and
- the device comprises a switch (34) that is electrically connected between the core and the cladding in order to pass from the first waveguide in which the core and the cladding are electrically insulated from each other to the second waveguide in which the core and the cladding are short-circuited.

7. Device according to Claim 5, wherein the first end (118) of the second waveguide (114) includes a metal plate (120) extending from the central core to the cladding in order to short-circuit the core and the cladding and to obstruct only one portion of the cross section of the dielectric material through which the electromagnetic waves reflected from the sample propagate.

8. Device according to Claim 7, wherein the second waveguide (114) is identical to the first waveguide (112) with the exception that it includes said metal plate (120).

9. Device according to any one of Claims 5 to 8, wherein the cladding (14) completely encircles the core (16).

Fig.1

Fig.2

Fig.3

Fig.4

Fig.6

Fig.5

Fig.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2651580
- US 20070090846 A1
- JP 2002214161 A
- US 2008191711 A
- FR 2905761